# EUROPÄISCHE PATENTSCHRIFT

(11) **EP 0 505 865 B1**
(45) Veröffentlichungstag und Bekanntmachung des Hinweises auf die Patenterteilung: **01.03.1995**
(21) Anmeldenummer: 92104453.3
(22) Anmeldetag: 16.03.1992
(51) Int. Cl.: G03B 27/20

(54) **Verfahren zur Belichtung von Druckplatten**
Method of exposing printing plates
Méthode d'exposition de plaques d'impression

(30) Priorität: 27.03.1991 DE 4110025
(43) Veröffentlichungstag der Anmeldung: 30.09.1992
(73) Patentinhaber: SIEGFRIED THEIMER GRAFISCHE GERÄTE GmbH, 63633 Birstein (DE)
(72) Erfinder: Vogel, Helmut, W-6486 Brachttal 5 (DE)
(74) Vertreter: Nix, Frank Arnold, Dr.

(56) Entgegenhaltungen:
- EP-A- 0 319 904
- US-A- 4 243 317
- PATENT ABSTRACTS OF JAPAN vol. 7, no. 260 (P-237)(1405) 18. November 1983 & JP A 58142327
- P. GLAFKIDES 'CHIMIE ET PHYSIQUE PHOTOGRAPHIQUES' 1976 , MONTEL , PARIS, Seite 864

## Beschreibung

Die vorliegende Erfindung bezieht sich auf ein Verfahren zur Belichtung von Druckplatten in einem Belichtungsgerät mit Vakuumerzeugung im Raum der Unterbringung der Kopierpartner (Druckplatte und Kopiervorlage) zwischen einer Glasplatte und einer Unterlage.

Die für den Offsetdruck verwendeten Druckplatten bestehen üblicherweise aus einem Aluminiumblatt, auf das eine mit Diazosalzen lichtempfindlich gemachte Harzschicht aufgebracht ist. Dieses Harz nimmt beim späteren Drucken die ölige Druckfarbe an und überträgt sie auf den Gummizylinder der Druckmaschine. Die Entfernung der Harzschicht auf den nicht druckenden Bereichen der Platte, also üblicherweise dem größeren Teil der Plattenoberfläche, geschieht dadurch, daß die Platte durch die Kopiervorlage hindurch belichtet wird, wobei in den vom Licht getroffenen Bereichen eine fotochemische Reaktion stattfindet, durch die das Diazo-Harz für einen alkalischen Entwickler lösbar wird. Bei dieser Reaktion entsteht eine geringe Menge Stickstoffgas.

Für die Schärfe des Druckbildes kommt es wesentlich auf einen innigen Kontakt zwischen der Kopiervorlage und der Druckplatte während der Belichtung an. Diese werden deshalb in einem Vakuumkopierrahmen belichtet, in dem sie sich zwischen einer Gummimatte und einer Glasplatte befinden, zwischen denen ein Unterdruck (üblicherweise Vakuum genannt) erzeugt wird, welches ein flächiges Zusammendrücken der Kopierpartner bewirkt. Es gibt viele verschiedene Techniken, eventuell eingeschlossene Luft zwischen den Kopierpartnern vor dem Schließen des Vakuumrahmens und während des Einleitens des Vakuums zu entfernen, Siehe z.B.EP-A-0 319 904.

Einen bisher nicht beachteten negativen Einfluß auf die Kopierqualität der Belichtung hat die eingangs beschriebene Entstehung von Gas während der Belichtung. Diese an sich geringe Menge Gas nimmt im zwischen den Kopierpartnern herrschenden Vakuum aber ein nicht unwesentliches Volumen ein und kann diese stellenweise voneinander abheben, sodaß es hier zu den gefürchteten "Vakuumflecken" oder Hohlkopien kommt.

Das durch die Gasentwicklung beim Belichten bewirkte Abheben der Kopierpartner wird auch in der US-A-4 243 317 angesprochen, die jedoch das Problem einer dadurch verursachten Relativbewegung der Kopierpartner zueinander löst.

Aufgabe der Erfindung ist es, aufzuzeigen, wie die Kopierqualität bei der Belichtung von Druckplatten weiter verbessert werden kann.

Die Lösung dieser Aufgabe gelingt dadurch, daß der Belichtungsvorgang nach einer ersten Phase hoher Gasentwicklung wenigstens einmal für eine zum Absaugen des entstandenen Gases ausreichende Zeit unterbrochen wird.

Der Erfindung liegt mithin die Erkenntnis zugrunde, daß das bei der Belichtung entstehende Gas - bei den üblichen Diazoplatten also Stickstoffgas - eine Beeinträchtigung der Kopierqualität bewirken kann und dieser Beeinträchtigung durch einfaches Einhalten einer Belichtungspause entgegengewirkt werden kann.

Diese Möglichkeit besteht deswegen, weil auch während der durch das Vakuum im Kopierrahmen bewirkten innigen Berührung zwischen den Kopierpartnern zwischen diesen vorhandenes Gas langsam abfließen kann. Dies ist deswegen möglich, weil sowohl die Oberseite der Druckplatte als auch die Unterseite der Kopiervorlage (des Films) eine matte Beschichtung aufweisen, die einen geringen Abstand zwischen diesen aufrechterhalten, der einerseits eine gewisse Schnelligkeit des Herausdiffundierens von eingeschlossenem Gas ermöglicht, aber andererseits die Kopierqualität nicht nennenswert verschlechtert.

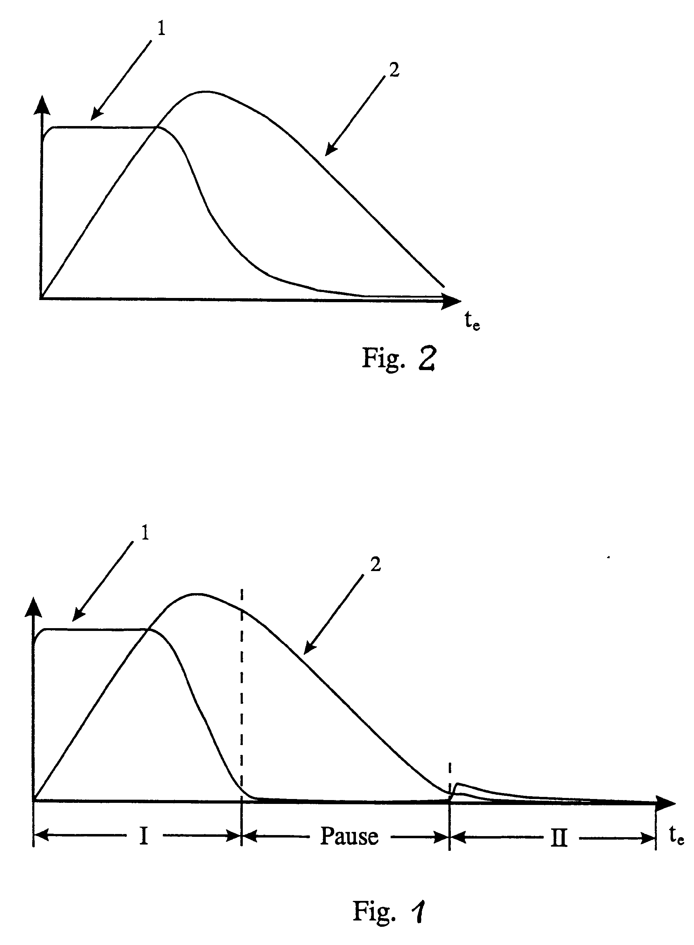

Hinzu kommt, daß eine übliche Belichtungszeit das Doppelte dessen beträgt, was zur vollständigen fotochemischen Reaktion eines belichteten Bereichs notwendig ist. Während der zweiten Hälfte der Belichtungszeit finden Reaktionen dann nur noch in den Übergangszonen zwischen belichteten und unbelichteten Bereichen statt, welche für die Schärfe der Kopie entscheidend sind. Diese Erkenntnis bedeutet gleichzeitig, daß die größte Menge des entstehenden Gases während der ersten Hälfte der Belichtungszeit auftritt, sodaß der Vorgang gedanklich in zwei Phasen unterteilt werden kann. Dies wird nachfolgend anhand der qualitativ zu verstehenden Diagramme gemäß Fig. 1 und 2 weiter erläutert.

Fig. 2 zeigt einen üblichen Belichtungsvorgang. Über der Zeit t ist mit der Kurve 1 die Entstehung des Stickstoffgases qualitativ gezeigt. Sofort mit Beginn der Belichtung setzt die Gasentwicklung in einer gewissen Stärke (Menge pro Zeit) ein, die eine gewisse Zeitspanne ungefähr konstant bleibt und dann nach einer gewissen Gesetzmäßigkeit abfällt. Die während der ersten Zeitspanne etwa konstanter Gasentwicklungsstärke entstehende zeitbezogene Gasmenge ist größer, als durch den Zwischenraum zwischen den Kopierpartnern entweichen kann, sodaß die zwischen diesen vorhandene Gasmenge ansteigt. Diese Menge ist qualitativ durch die Kurve 2 gezeigt.

Wenn die entstehende zeitbezogene Menge so weit abgefallen ist, daß sie die Menge erreicht, die den Zwischenraum zwischen den Kopierpartnern verlassen kann, steigt die vorhandene Menge nicht weiter an und diese beginnt wieder abzufallen. Dabei entspricht der in Fig. 2 gezeigte Verlauf etwa den Vorgängen bei üblicher Belichtung, bei der während der gesamten Zeitdauer der Belichtung eine das Kopierergebnis verschlechternde Gasmenge eingeschlossen ist.

Die Belichtungszeit tₑ (tₑ = Ende der Belichtung) hängt in erster Linie von der Beleuchtungsstärke (Leistung der Lichtquelle und deren Abstand) sowie der Empfindlichkeit der zu belichtenden Druckplatte ab und kann zwischen 5 sec und 5 min liegen, wobei in der Praxis Zeitspannen zwischen 30 und 120 sec am häufigsten sind.

Fig. 1 zeigt qualitativ die Vorgänge beim vorgeschlagenen Verfahren. Hier wird nach einer ersten Phase I, die etwa der Zeitspanne konstanter Gasentwicklungsstärke entspricht, eine Belichtungspause eingelegt. Dadurch fällt die Gasentwicklung sofort auf nahezu Null ab, sodaß auch die Kurve 2 der vorhandenen Menge ziemlich zügig abfällt. Wenn die vorhandene Menge auf einen unschädlichen Restbetrag abgesunken ist, wird die Pause beendet und die zweite Belichtungsphase II beginnt. Es kommt nochmals zu einem jetzt aber nur wesentlich kleineren Sprung mit anschließendem Abfall der Gasentwicklungskurve 1, wobei die entsprechend dieser Kurve noch freigesetzte Gasmenge aber keinen wesentlichen Einfluß mehr auf die vorhandene Menge hat.

Es ist zu sehen, daß in der zweiten Phase II, in der die feinen Konturen der druckenden Bereiche an den Übergangsstellen von diesen zu den nicht druckenden Bereichen ausbelichtet werden, praktisch kein Gas zwischen den Kopierpartnern eingeschlossen ist, sodaß sehr gute Kopierergebnisse zu erwarten sind.

Vorteilhafterweise geschieht die Aufteilung der Gesamtbelichtungszeit bei einmaliger Unterbrechung des Belichtungsvorgangs auf die beiden Phasen in der Weise, daß in einer ersten Phase 30 bis 60 %, vorteilhafterweise 40 bis 50 % und insbesondere 45 % der gesamten Lichtmenge eingestrahlt wird. Die Pause kann demnach zwischen 3 und 150 sec betragen, wobei für die in der Praxis häufigsten Belichtungszeiten die Pausenzeiten zwischen 15 und 60 sec, vorteilhafterweise zwischen 30 und 50 sec liegen.

Die oberen Werte innerhalb der angegebenen Bereiche gelten für größere Formate. Außerdem werden bei den kürzeren Belichtungszeiten die Pausenzeiten die längeren sein, weil bei den kürzeren Belichtungszeiten die Gasentwicklung eine stärkere ist.

Die Unterbrechung der Belichtung wird man üblicherweise so vornehmen, daß die verwendete Metall-Halogenid-Lampe mit einem mechanischen Klappenverschluß abgedeckt und die zugeführte elektrische Leistung so weit verringert wird, daß nach Beendigung der Wartephase die Restbelichtung bei noch betriebswarmer Lampe fortgesetzt werden kann. Dazu wird dann diese Klappe wieder geöffnet und die elektrische Leistung auf den Betriebswert erhöht.

Meist wird eine einmalige Unterbrechung der Belichtung entsprechend dem, was Fig. 1 qualitativ zeigt, genügen. Es kann jedoch auch eine mehrmalige Unterbrechung des Belichtungsvorgangs zweckmäßig sein, und zwar jeweils dann, wenn eine die Kopierqualität beeinträchtigende Gasmenge sich angesammelt hat.

Bei einer zweimaligen Unterbrechung des Belichtungsvorgangs ist es zweckmäßig, in jeder der drei Belichtungsphasen 15 bis 40 % der gesamten Lichtmenge einzustrahlen und die beiden Pausen mit 3 bis 100 sec, vorzugsweise 10 bis 40 sec vorzusehen, wobei es im allgemeinen vorteilhaft sein wird, wenn die erste der beiden Pausen länger als die zweite gewählt wird.

## Patentansprüche

1. Verfahren zur Belichtung von Druckplatten in einem Belichtungsgerät mit Vakuumerzeugung im Raum der Unterbringung der aus Druckplatte und Kopiervorlage bestehenden Kopierpartner zwischen einer Glasplatte und einer Unterlage,
dadurch gekennzeichnet, daß der Belichtungsvorgang nach einer ersten Phase (I) hoher Gasentwicklung (1) wenigstens einmal für eine zum Absaugen des entstandenen Gases ausreichende Zeit unterbrochen wird.

2. Verfahren nach Anspruch 1, dadurch gekennzeichnet, daß die Zeitdauer der ersten Phase 30 bis 60 %, insbesondere 40 bis 50 % der gesamten Belichtungszeit ausmacht.

3. Verfahren nach Anspruch 2, dadurch gekennzeichnet, daß die Zeitdauer der Pause zwischen 3 und 150 sec, besonders zwischen 15 und 60 sec und speziell zwischen 30 und 50 sec gewählt wird.

## Claims

1. Process for exposing printing plates in an exposure device with the production of a vacuum in the space for housing the copying participants comprising the printing plate and copying original,between a glass plate and a base, characterised in that the exposure process after a first phase (I) of high gas generation (1) is interrupted at least once for a time sufficient to draw out the resultant gas.

2. Process according to claim 1, characterised in that the duration of the pause constitutes 30 to 60 %, in particular 40 to 50 % of the entire exposure time.

3. Process according to claim 2, characterised in that the period of the pause is selected between 3 and 150 seconds, particularly between 15 and 60 seconds and specially between 30 and 50 seconds.

## Revendications

1. Procédé d'insolation de plaques d'impression dans un appareil d'insolation avec génération d'une dépression entre une plaque de verre et un support, dans la chambre où est placé le couple d'éléments à copier, formé de la plaque d'impression et du document à copier, caractérisé par le fait que l'on interrompt au moins une fois le processus d'insolation, après une première phase (I) de fort dégagement gazeux (1), pendant un temps suffisant pour permettre l'évacuation du gaz formé.

2. Procédé selon la revendication 1, caractérisé par le fait que la durée de la première phase représente 30 à 60 %, en particulier 40 à 50 % du temps d'insolation total.

3. Procédé selon la revendication 2, caractérisé par le fait que la durée de la pause est choisie entre 3 et 150 secondes, notamment entre 15 et 60 secondes et plus particulièrement entre 30 et 50 secondes.
